# EUROPEAN PATENT APPLICATION

(11) **EP 4 836 663 A1**
(43) Date of publication of application: **04.11.2026**
(21) Application number: 25382429.6
(22) Date of filing: 29.04.2025
(51) Int. Cl.: H10N 30/06

(54) **LASER MICROMACHINED MICROCIRCUITS, METHOD FOR MANUFACTURING AND USES THEREOF**

(71) Applicant: Universidad De Zaragoza, 50009 Zaragoza (ES); Consejo Superior de Investigaciones Científicas (CSIC), 28006 Madrid (ES); Universidad de Sevilla, 41013 Sevilla (ES)
(72) Inventor: ANGUREL LAMBÁN, Luis Alberto, 50018 Zaragoza (ES); FRECHILLA ZABAL, Alejandro, 50018 Zaragoza (ES); DE LA FUENTE LEIS, Xermán Francisco, 50018 Zaragoza (ES); BORRÁS MARTOS, Ana Isabel, 41092 Sevilla (ES); RODRÍGUEZ GONZÁLEZ- ELIPE, Agustin, 41092 Sevilla (ES); DEL MORAL JALÓN, Jaime, 41092 Sevilla (ES); GIL ROSTRA, Jorge, 41092 Sevilla (ES); MARTÍNEZ OLAIZOLA, Mikel, 41092 Sevilla (ES); LÓPEZ SANTOS, María del Carmen, 41092 Sevilla (ES)
(74) Representative: TRBL Intellectual Property

(57) **Abstract**

The present invention relates to a laser micromachining method for manufacturing microcircuits, the method comprising: arranging an electrically conductive material on an sound responsive substrate, both having similar laser-induced damage thresholds, LIDT; patterning the electrically conductive material with femtosecond, fs, laser pulses; monitoring a sound response of the substrate and of the electrically conductive material under the application of the laser pulses; and controlling the micromachining process to avoid ablating the substrate. The invention also relates to a system for manufacturing microcircuits, and to the use of said system to manufacture a transducer, an electrode, a reflector, an antenna, a microchannel, a micro electromechanical system or a circuit probe.

## Description

### FIELD OF THE INVENTION

The present invention belongs to the technical field of laser micromachining. More specifically, the invention relates to microcircuits acting as electrodes, interdigital transducers, micro electromechanical systems (MEMS), microchannels, reflectors or antennas, manufactured from electrically conductive materials arranged over substrates, by means of ultra-short pulse lasers. The invention also relates to laser micromachining systems and uses thereof.

### BACKGROUND OF THE INVENTION

Microcircuits are circuits such as electrodes, waveguides, microchannels, antennas, or reflectors, typically with characteristic lengths, widths or inter-electrode distances in the micrometric scale, and thicknesses in the range of hundreds of nanometers. These devices are widely used in electrochemistry, sensor technology, energy conversion and storage, microfluidics and photonics, as well as in radio-based communications and wireless transmission systems, such as horn antennas, bolometers, high-frequency circuit probes, and other passive elements.

In addition to these applications, microelectrodes arranged as interdigital transducers (IDT) for generating bulk and surface acoustic waves are also known. Surface acoustic waves (SAV) and other types of acoustic waves (AW) (e.g., plate or other bulk waves) are applied in different sectors such as, for instance, in wireless communications as radiofrequency filters, as transducers for physical and biochemical sensing, in microfluidic platforms, or in cleaning and de-icing applications, among others.

AW transducers are usually fabricated by patterning one or various IDTs on a piezoelectric substrate (for instance, lithium niobate (LiNbO₃)) or on a piezoelectric film (typically, zinc oxide (ZnO), aluminum nitride (AIN) or barium titanate (BTO)) deposited on a support preferably made of glass, metal, ceramic or polymer. These transducers transform a radiofrequency signal into AWs that propagate along the surface of the piezoelectric substrate, or through plates compatible with the propagation of AWs in a superstrate configuration, regardless of their piezoelectric character. The geometry and dimensions of the IDTs strongly define the wave mode and frequency of the generated AWs.

Supported IDTs and microcircuits are generally fabricated using photolithography and lift-off methods. These processes are highly demanding in terms of conditions of the substrate (e.g., planarity, cleanness, etc.) and processing environment. They also face limitations regarding the size and shape of the substrates, as well as of the resulting microcircuits. Usually, these methods require multiple and complicated steps that must be performed in cleanroom environments, thereby producing an important quantity of chemical residues, making them extremely time-consuming and environmentally disadvantageous. Another alternative for their manufacturing is to clamp a printer circuit board with the desired IDT or microcircuit patterned on the substrate. In the latter option, obtaining a good physical contact between the IDT/electrode/microcircuit and the substrate is often a challenge. In consequence, there is an increasing demand for low-cost, accurate and environmentally-friendly methods for the preparation of these devices.

Femtosecond (fs) laser micromachining is a promising solution for high-precision and flexible fabrication of planar or 3D microstructures. In comparison with picosecond and nanosecond lasers, fs lasers provide higher irradiance values and transfer little or no heat to the illuminated target, significantly reducing or even eliminating the heat-affected zone (HAZ) associated with most laser machining processes. Reduction or elimination of the HAZ enables achieving high precision machining, as required for the fabrication of microcircuits and IDTs.

In the prior art, W. Wang and J. Qian ("Femtosecond Laser Micromachining of the Mask for Acoustofluidic Device Preparation", ACS Omega (2023), 8, 7838-7844) have proposed the use of fs laser micromachining to fabricate a mask on 10 µm thick steel foils, where the laser emits in the n-IR region of the electromagnetic spectrum (1030 nm) with a pulse repetition frequency of 2 kHz, powers of 80-100 mW and sample movement at 0.25-0.35 mm/s. Once the mask is placed on the piezoelectric substrate, a metal layer (Cr/Au) is deposited using a vacuum evaporation coating system. This technology can also be applied to flexible substrates.

Transparent conductive oxides (TCO) and, in particular, indium tin oxide (ITO), are also an alternative to fabricate microelectrodes with different configurations. Usually, lithography or wet etching are some of the most used fabrication technologies.

Several studies have investigated the ablation process associated with the laser micromachining of ITO circuits using different laser sources. Some of them include nanosecond pulsed laser emitting ultraviolet (250 - 350 nm) radiation (G. Singh et al., "Excimer laser micromachining of indium tin oxide for fabrication of optically transparent metamaterial absorbers", Appl. Phys. A Mater. Sci. Process. 125 (2019) 1-14), or in near-infrared wavelengths (around 1064 nm) (C. Molpeceres, et al., "Microprocessing of ITO and a-Si thin films using ns laser sources", J. Micromechanics Microengineering. 15 (2005) 1271-1278). Other studies are focused on ultra-short laser processing, with pulse durations in the range of femtoseconds or few picoseconds. Other reports include emission wavelengths of 700 - 800 nm (C.W. Cheng, C.Y. Lin, "High precision patterning of ITO using femtosecond laser annealing process", Appl. Surf. Sci. 314 (2014) 215-220) or longer wavelengths of 1030 nm (S. Krause et al., "Precise microstructuring of indium-tin oxide thin films on glass by selective femtosecond laser ablation", EPJ Photovoltaics. 4 (2013) 2-6).

However, the application of the known techniques to substrates (understood either as bulk supports or as supported layers) that have a damage threshold similar to the ITO, as it is the case of widely employed piezoelectric materials such as ZnO or AIN thin films, remains a challenge in the art. Accordingly, in the present field there is a need for methods suitable for laser machining low-thickness and electrically-conductive materials without damaging the substrates, while also achieving well-defined edge profiles of the microcircuits, for instance, electrodes and IDTs, as required for AW and SAW leveraged devices.

### SUMMARY OF THE INVENTION

The present invention overcomes the limitations of the prior art by providing a laser micromachining method for manufacturing microcircuits based on electrically conductive materials arranged on substrates or supported layers. In this method, a sound signal generated by the electrically conductive materials and the substrate is monitored while the laser is applied thereon. The method is particularly advantageous for patterning electrically conductive materials having a laser ablation response, in terms of their laser-induced damage threshold (LIDT), similar to the substrate on which they are arranged.

For the interpretation of the present invention, the LIDT will be understood as the limit at which a material is ablated or damaged by a laser given its delivery of output power. However, and even though the embodiments of the invention will be generally described with reference to said output power, the invention will be equivalently applicable to other laser parameters such as the fluence (energy per area), intensity or irradiance (power per area) and/or the wavelength and the particular laser scanning parameters or the scanning path to which a damage threshold can be related, as it will be apparent to the skilled person. Therefore, a change in any of these parameters, using one or several laser sources, can potentially influence the laser output power delivered to the conductive material and the substrate of the microcircuit.

For the interpretation of the present invention, the expression "substrate" refers to the surface on which the electrically conductive material is supported. This term involves both bulk materials (for example, fused silica, glass, piezoelectric plate like LiNbO₃, polymeric foil) and thin films interfacing with the electrically conductive material forming a multilayer with the electrically conductive material (for example, ZnO, TiO₂, SiO₂, other TCO, polymeric thin film).

For the interpretation of the present invention, the expression "electrically conductive material" refers to a thin film, a coating or to other arrangement of materials, preferably with a thickness between 50 nm and 1000 nm, deposited or fabricated by any solvent, vacuum, chemical or physical mean on top of the substrate material, that is designed to be machined (processed, shaped or structured) for the final formation of a microcircuits suitable for transporting or conducting an electrical current, either acting as electrodes, interdigital transducers, micro electromechanical systems (MEMs), microchannels, reflectors or antennas. In different embodiments of the invention, these materials can also be further post-processed by laser or thermal annealing, or any other method to enhance its electrical conductivity. In the case of transparent conductive material, the post-processing treatment can also be performed to enhance its optical properties, as for instance, its transparency.

In addition, for the interpretation of the present invention, the expression "sound responsive" applied to the substrate, will be understood as any substrate material able to generate a characteristic sound (i.e. a sound signal which is distinguishable from other sound signals associated to the patterning of the electrically conductive material) when a portion of its volume is ablated during the interaction with a laser beam. This can also be applied to the electrically conductive material, such that said sound response can be monitored and/or recorded through a sound sensor such as, for instance, a microphone. Other monitoring means, such as mechanical or electromechanical sensors adapted to detect a sound response, will be understood as equivalent sound sensors within the scope of the invention. It is to be noted that the expression "sound responsive" will not be understood, in the context of the invention, as any other generic property for sound generation, AW generation, or transduction, but just to the generation of sound signals that can be directly identified with the ablation of the substrate and/or the supported thin film conductive material.

More specifically, one aspect of the invention relates to a laser micromachining method for manufacturing microcircuits, the method comprising the following steps:
a) providing a sound responsive substrate, said substrate comprising a first LIDT;
b) arranging an electrically conductive material on the substrate, wherein the electrically conductive material is also sound responsive and comprises a second LIDT, and wherein the second LIDT is comprised between 50% and 150% of the first LIDT;
c) patterning the electrically conductive material with one or more micromachining circuit patterns by applying, during one or more time intervals, a plurality of laser pulses comprising an output power which is delivered to the electrically conductive material, using one or more femtosecond, fs, laser sources; wherein the output power is equal or higher than the second LIDT, thereby ablating the electrically conductive material;
d) monitoring, during step c), a sound response of the substrate and the electrically conductive material;
e) controlling, in response to the monitoring of step d), the delivery of output power of the laser pulses during one or more of the time intervals of step c), such that the delivered output power is adjusted to a value which is lower than the first LIDT, thereby avoiding ablating the substrate.

Thereby, and through a suitable selection of laser parameters during the controlling step e), the method of the invention allows the confinement of the volume that has been affected by the laser in the electrically conductive material, controlling the ablated thickness and the lateral resolution at any moment, with precision at the nanometric or submicrometric scales. Therefore, with the present invention the electrically conductive features of the resulting microcircuit, as well as other properties such as its transparency, can be conveniently preserved and controlled along the manufacturing process.

Also, the method of the invention provides an advantageous solution to remove the electrically conductive materials following laser sweeping steps or paths, minimizing the laser energy that reaches the surface of the substrate, thereby preventing its ablation and preserving its properties.

As mentioned above, the method is particularly advantageous for patterning electrically conductive materials having a second LIDT comprised between 50% and 150% of the first LIDT of the substrate. However, in preferred embodiments of the invention, the second LIDT can be comprised between 60% and 140% of the first LIDT; between 70% and 130% of the first LIDT between 80% and 120% of the first LIDT; between 90% and 110% of the first LIDT; between 95% and 105% of the first LIDT; between 70% and 100% of the first LIDT; between 80% and 100% of the first LIDT; between 90% and 100% of the first LIDT; and between 95% and 100% of the first LIDT.

In a further preferred embodiment of the invention, the micromachining circuit pattern comprises a transducer (understood as an electrical transducer or an electrically active element), more preferably an IDT. And, under this or other embodiments, the substrate comprises a piezoelectric material, preferably LiNbO₃, quartz, ZnO, AIN, BaTiO₃, PVDF or PVDF-TrFE.

In a further preferred embodiment of the invention, the micromachining circuit pattern comprises an electrode, a reflector, an antenna, a micro electromechanical system (MEMS), a microchannel or a circuit probe.

In a further preferred embodiment of the invention, the electrically conductive material comprises an electrically conductive oxide material, preferably a transparent conductive oxide (TCO) material. More preferably, the TCO material comprises ITO, aluminum-doped zinc oxide (AZO), gallium-doped zinc oxide (GZO), and/or fluorine-doped tin oxide (FTO), metal nanostructures, conducting polymers, or combinations of these materials forming composites or multilayers.

In a further preferred embodiment of the invention, the electrically conductive material is arranged as a layer on the substrate, and comprises a thickness of between 50 nm and 1000 nm.

In a further preferred embodiment of the invention, a piezoelectric substrate, particularly in the form of thin film, is arranged on a support material comprising glass, ceramic, a metal or a polymer.

In different embodiments of the invention, the application of laser pulses during step c) comprises one or more consecutive passes over a same region or a part of it of the electrically conductive material. In a preferred embodiment, the one or more consecutive passes are applied at a same output power. Alternatively, the one or more consecutive passes are applied at a different output power and, more preferably, the output power of one pass is less than the power of its consecutive pass.

In different embodiments of the invention, the one or more consecutive passes are applied parallel to each other over the region of the conductive material. Alternatively, the one or more consecutive passes are applied at different scanning directions to each other over the region of the conductive material. These alternatives allow for different laser sweeping options to pattern the electrically conductive material.

In a further preferred embodiment of the invention, the laser pulses comprise a duration between 10 fs and 5000 fs, and/or a wavelength between 257 nm and 1030 nm.

In a further embodiment, the laser pulses are modified using a temporal pulse shaping option based on a "bi-burst" technique.

In a further preferred embodiment of the invention, in step c) of the method, the one or more fs laser sources comprise a plurality of fs laser sources with different output powers, and step e) comprises selecting one of the plurality of fs laser sources.

In a further preferred embodiment of the invention, the method comprises an additional step of applying a thermal annealing treatment to the arrangement of the conductive material on the piezoelectric substrate. A pre- or post-thermal annealing can be applied to reduce stresses generated during the fabrication of the electrically conductive material, or to improve the electrical and optical properties of the final microcircuit.

In a further preferred embodiment of the invention, the one or more fs laser sources comprise at least an infrared (IR) laser, a green laser or an ultraviolet (UV) laser.

A second aspect of the invention relates to a system for manufacturing a microcircuit, said system comprising:
- one or more fs laser sources adapted for patterning a conductive material arranged on a sound responsive substrate by applying, during one or more time intervals, a plurality of laser pulses comprising an output power to the conductive material;
- a sound detector adapted to monitor a sound response of the substrate and of the conductive material used to fabricate the microcircuit to the application of the laser pulses;
- a controller communicatively connected to the one or more fs laser sources.

Advantageously in the invention, the one or more fs laser sources, the sound sensor and the controller are adapted to perform the method according to any of the embodiments described in the present document.

As disclosed above, in a preferred embodiment of the invention, the sound sensor comprises a microphone adapted to acquire an airborne sound signal of the substrate during the application of the laser pulses to the electrically conductive material. For different embodiments of the invention, the sound signal can be obtained in one or more frequency ranges of 20 Hz to 10 kHz. An analog-to-digital converter connected to a computer can also be used to sample the sound amplitude, under one or more sampling rates. Alternatively, other mechanical sensors can be used for monitoring the generated sound during the ablation process.

A third aspect of the invention relates to the use of a system according to any of the embodiments described in the present document, for manufacturing a transducer, an electrode, a reflector, an antenna, a micro electromechanical system, a microchannel or a circuit probe.

Other aspects and embodiments of the invention are described in the claims.

All the terms and embodiments described anywhere in this document are equally applicable to all aspects of the invention. It should be noted that, as used in the specification and in the appended claims, the singular forms "a", "an", and "the" include their plural referents unless the context clearly indicates otherwise. Similarly, the term "comprises" or "comprising" as used herein also describes "consists of" or "consisting of" in accordance with generally accepted patent practice. Furthermore, any of the parametric ranges and/or single parameter values described in the examples can be used, in different embodiments of the invention, in isolation or in combination.

### DESCRIPTION OF THE DRAWINGS

The foregoing and other features and advantages will be more fully understood from the detailed description of the invention, as well as from examples referring to the attached figures, which are described in the following paragraphs, wherein:
Figures 1A-1B show general and detailed micrographs, respectively, of the surface of an electrically conductive material on ZnO after the application of a laser treatment with 0.8 W of output power.
Figures 2A-2B show the examples of Figures 1A-1B, respectively, after having applied a laser treatment with a power of 1.35 W.
Figures 3A-3B show micrographs of the surface of the electrically conductive material on ZnO after the application of a two-step laser treatment, the first one with a power of 0.8 W, and the second one with a power of 0.68 W.
Figure 4 shows the S₁₁ component (in dB) response spectrum (as a function of the frequency, in MHz) of a SAW resonator based on an ITO IDT fabricated on LiNbO₃ using the method proposed in this invention.
Figures 5 and 6 show damage threshold values of Glass / ITO + glass, lithium niobate (LNO) / ITO + LNO, ZnO + Glass / ITO + ZnO + Glass, expressed in µJ/pulse (Fig. 5) and as ratios (Fig. 6).
Figures 7A-7B show confocal microscopy profiles of two different IDTs made with 700 nm of ITO on 5 microns of ZnO, and a final glass substrate.

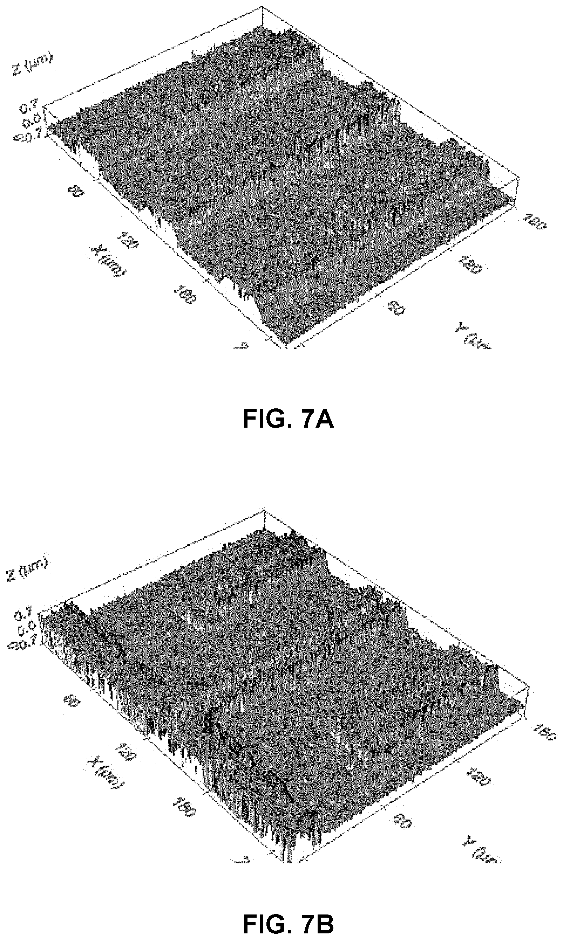

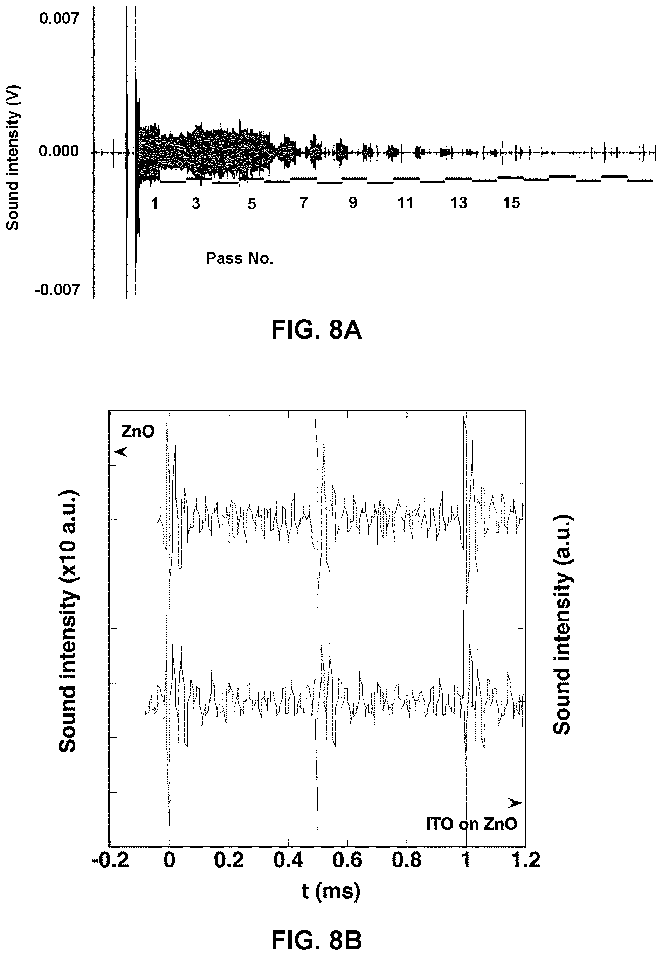

Figure 8A shows the temporal evolution of the sound intensity (in units associated to the voltage generated in the microphone) recorded in the definition of the processing conditions used to machine the IDT presented in Figure 7. Figure 8B shows the temporal evolution of the intensity of a sound signal recorded while two laser pulses of a laser treatment with 10.4 µJ/pulse and 2 kHz, reach an ITO layer deposited on ZnO, or directly a ZnO surface. It is to be noticed that the sound intensity is ten times higher when the laser treatment is applied on the ITO, and that characteristic differences between the shape of the sound signal are generated in each material.

### DETAILED DESCRIPTION OF THE INVENTION

The detailed description of the present invention refers to the accompanying drawings, which illustrate specific embodiments in which the present invention can be implemented.

These embodiments will be described sufficiently to enable those skilled in the art to carry out the present invention. It should be understood that various embodiments of the present invention can be different from each other, but are not to be interpreted as mutually exclusive. Accordingly, the embodiments described below are not intended to be taken in a limiting meaning, and the scope of the present invention, if properly described, is limited only by the appended claims, in addition to all scopes equivalent to those claimed by the appended claims.

### IDT example

An IDT with three pairs of paths with a width of 50 µm, and the same distance between two consecutive paths, was patterned on a 400 nm thick ITO thin film deposited on a ZnO substrate. The laser process was based on the combination of two treatments, both intended to effectively control the affection on the ITO layer, such sequence minimizing the interaction with the ZnO substrate surface in order to avoid its ablation.

The laser treatments were performed with an ultraviolet (343 nm) fs (238 fs) laser, using a hatching distance between two scanning lines of 6 µm. The laser processing was performed at low frequency (10 kHz), so as to control heat accumulation and increase ablation process efficiency. Reducing the heat accumulation helped to avoid damage to the substrate and nearby areas of the thin film, due to indirect heating. The laser scanned the ITO surface at a beam speed of 25 mm/s. Low beam displacement velocity enabled a more controlled ablation process, producing sharper edges and better-defined paths.

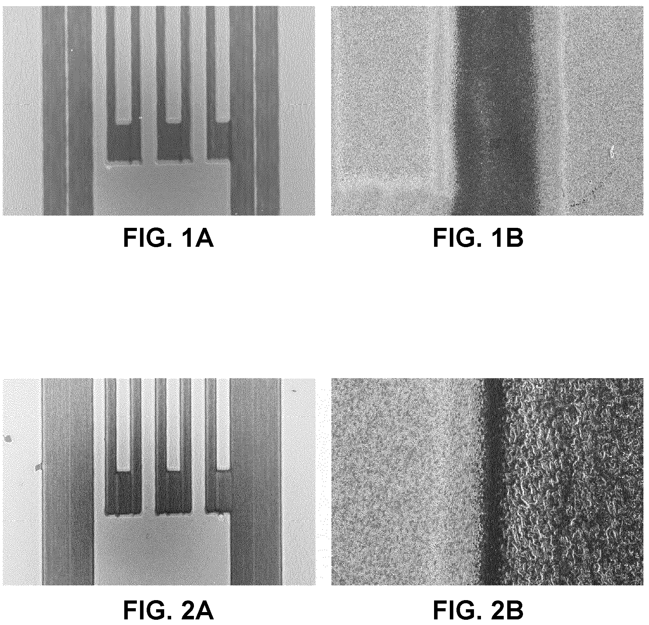

When the laser power was fixed to 0.8 W, the ITO area that was ablated (see dark regions in the micrographs presented in Figure 1) was not uniform. In some regions of the ablated area, small traces of ITO could still be observed. This effect could not be precisely controlled and, in some points, these regions could connect two consecutive paths, rendering the IDT useless.

If the laser power was increased up to 1.35 W, ITO paths were well defined but, when laser reached the ZnO substrate in the ablated areas, it started to modify its surface. Even when this affection was not so high (see Figure 2), generating a roughness of less than 1 µm, it could deteriorate the performance of the device, for instance, if the system is designed to propagate surface acoustic waves.

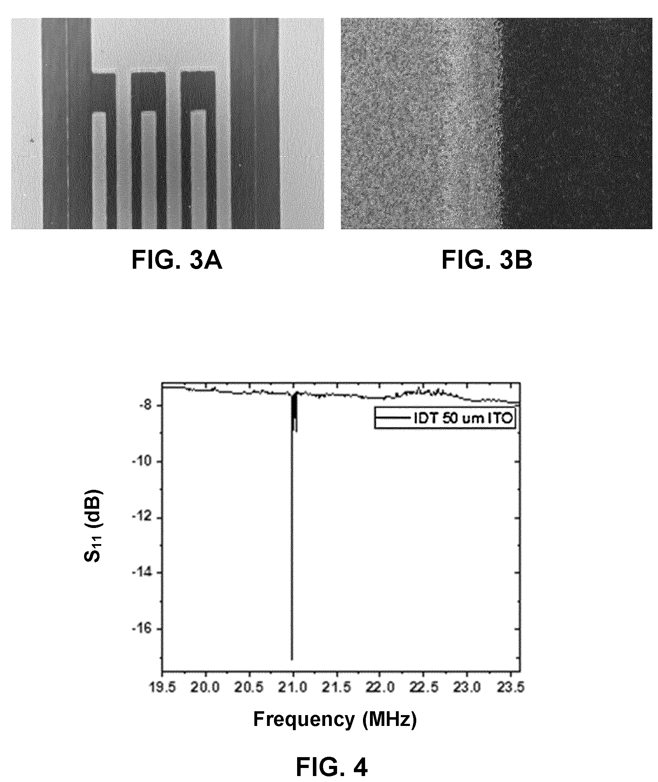

Both undesired effects were avoided by combining two laser treatments in a controlled way, according to the method of the present invention. In the micrographs presented in Figures 3A-3B, the first laser treatment corresponds to the treatment presented in Figure 1, with a power of 0.8 W (4 µJ/pulse). The best option for the second laser treatment was to reduce the laser power to ensure that ZnO was not affected by the laser treatment. In the case of the example presented in Figures 3A-3B, the power of this second laser treatment was reduced to 0.68 W (3.4 µJ/pulse) while the sound generated during the treatment is recorded with a microphone. The second treatment was performed in an opposite direction, with the laser lines parallel to the first laser step (starting where the first step finished). This particular configuration also helped to remove the small traces of ITO, thereby minimizing the damage on the substrate. Additionally, more defined edges on both ITO patterns were achieved.

As it will be understood, the above example can be generally applied, in different embodiments of the invention, to fabricate transducers and, more specifically, IDTs for generating surface acoustic waves. As an example, Figure 4 shows the S₁₁ component (in dB) response spectrum (as a function of the frequency, in MHz) of an AW resonator based on LiNbO₃. The IDT consist of 24 fringes with a width of 50 µm and a thickness of 300 nm. The Figure shows the response of the AW resonator exhibiting a very sharp plate acoustic wave resonance peak.

### LIDT characterization example

During the application of the laser treatments, the LITD ablation thresholds for different materials used to obtain circuits with TCO were evaluated, using glass, lithium niobate, and zinc oxide and ITO as ablated materials. For these experiments, a green laser working at 249 fs was used, sweeping at 2 kHz with a speed of 10 mm/s. To take into account that the response of the material was different when the laser hit the surface the first time, or on successive lines that already reach a surface that have been modified by the previous stages of the treatment, in the experiments the treatment was applied to a 25 micron-wide rectangle (5 lines, displacing each line by 5 microns).

To define the LIDTs, the sound generated during the process was monitored by varying the level of output power used in the laser treatments. The damage threshold was then defined by identifying the minimum level of power at which a sound signal identifiable with the ablation of the material was generated and has been confirmed by confocal microscopy measurements.

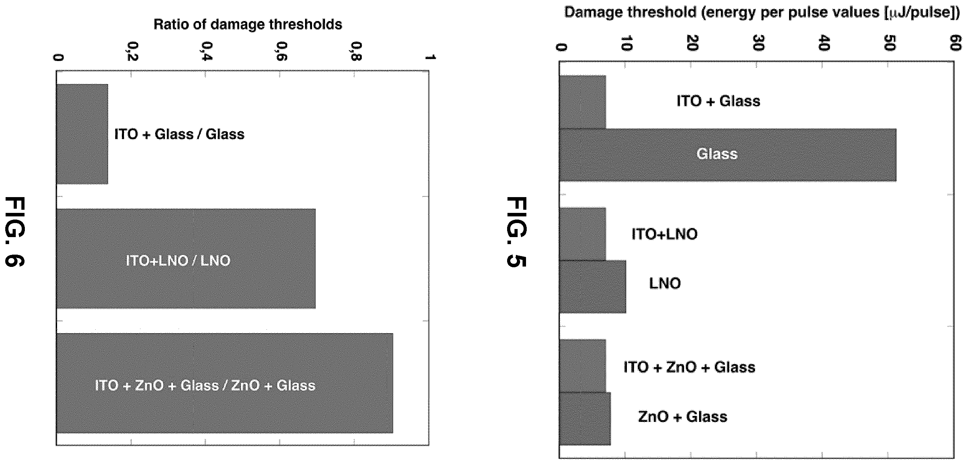

Figures 5 and 6 show that, when ITO is deposited on a glass substrate, the difference between the damage thresholds in the glass and in the ITO is very wide, and then an output energy of approximately seven times higher (7.2 times) is needed. This explains why it is easy to find processing conditions that allow the ITO layer to be removed without damaging the glass substrate, even using a single-pass treatment. This configuration is commonly observed in the prior art where laser techniques are used to machine ITO circuits.

On the contrary, when ITO is deposited on lithium niobate, this difference is reduced. The LIDT of ITO is a 70% of the LiNbO₃ value. And, when it is deposited on ZnO, the LIDT of ITO is a 90% of the substrate. It is in these situations that the present invention acquires its full advantage over the known techniques. By controlling the sound generated during the laser patterning treatment, the minimum energy that begins to affect the surface of the ITO can be determined, and the laser can be accurately controlled to avoid damaging the ZnO substrate. Moreover, the process can be repeated until the ITO is completely removed.

Figures 7A-7B show confocal microscopy profiles of two different IDTs made with 700 nm of ITO on 5 microns of ZnO, and a final glass substrate. Above the ITO there was a 34 nm layer of gold. To manufacture it, a treatment was carried out with fifteen passes using a power of 7.45 µJ/pulse just between the damage threshold of the ITO (7.1 µJ/pulse) and the ZnO (7.85 µJ/pulse). The sound recording, presented in Figure 8A (sound spectrum recorded in the definition of the processing conditions used to machine the IDT), showed that, during the first six passes, the laser treatment was removing the ITO layer. Between the passes seven to twelve, the ZnO substrate had already been reached in the central area, and ITO remains were being removed, mainly on the edges of the machined area. In the last few passes (thirteen to fifteen), the ITO layer had already been removed, and the ZnO surface was reached in the full width of the machined region without damaging it, as can be seen in the figures. Figure 8B shows another example of sound monitoring, related to the temporal evolution of a sound signal recorded during a laser treatment with 10.4 µJ/pulse and 2 kHz, applied to an ITO layer deposited on ZnO, or directly on the ZnO. This level of laser energy can ablate the ITO and the ZnO. This figure demonstrates the strong difference in the amplitude of the sound signal generated for a given laser treatment when the laser reaches the surface of a material or the other. The amplitude of the sound signal when the laser is machining the ITO coating is 10 times higher than the corresponding to the ZnO under the same laser conditions. Also, the shape of the sound signal associated with each pulse presents characteristic features that can be identified with the presence or absence of the ITO layer (i.e., before and after the ZnO starts being ablated), thereby providing a means to distinguish the precise moment in which the laser parameters must be controlled to avoid harming the substrate.

It is to be noted that, generally in the invention and as illustrated in Figures 8A-8B, the sound signal changes abruptly when the laser reaches the surface of the substrate. As a result, its sound monitoring and the associated control of the laser output power can be performed without the need of a previous characterization of the materials forming the microcircuit or other previous information. However, in further embodiments of the invention, the monitoring and control steps of the method can be supplemented by establishing specific sound threshold values (either in the spectra, the temporal evolution or in other sound properties) which are determined *a priori* and mark the moments in which the substrate starts being ablated by the laser. Also, the method can include supplementary monitoring means based on other physical properties, such as optical methods to monitor the electrically conductive material or the substrate while the laser is applied. These optical means include, for instance, laser-induced breakdown spectroscopy.

In further embodiments of the invention, the monitoring and controlling steps of the method can be performed manually or automatically. Automatic monitoring and control include the use of computerized means, or based on artificial-intelligence to process the sound signals and analyzing them, as well as for determining the control command sent to the laser (start, stop, modify output power, switch laser means, change sweeping trajectories, etc.).

As described above, the present invention proposes a novel micromachining method using fs lasers (preferably green or UV) that can be applied, preferably, to micromachine ITO or any other type of TCO thin films (e.g., AZO, GZO, FTO) with thicknesses of the order of 50 nm - 1000 nm and deposited on substrates that exhibit ablation threshold values similar to the TCO. Also, the method can be generally applied to other electrically conductive materials and to non-piezoelectric substrates.

An adequate selection of the laser parameters while the sound signal of the substrate is monitored allows the confinement of the volume that has been affected by the laser, thereby controlling the thickness of the material that is ablated, with a high in-depth and lateral resolutions. A plurality of different laser treatments can be combined in the same method, applying energy values just above the ablation threshold of ITO or the used TCO or electrically conductive film. This facilitates the removal of the ITO (TCO) layer in several steps, while minimizing the laser energy that reaches the surface of the substrate. This facilitates the possibility of removing the ITO (TCO) layer minimizing the affection in the substrate, even if the damage threshold of the substrate is very similar to the damage threshold of ITO.

Even more advantageously, the method of the invention is less sensitive to small changes in the surface planarity in contrast to other known techniques, such as photolithography, and can be applied to large-size substrates without limitations and in continuous production processes. In addition, the present laser technology can be applied to generate pre- or post-thermal annealing to reduce stresses generated during the fabrication of the initial thin film, or to improve the properties of the final designed device.

## Claims

1. Laser micromachining method for manufacturing microcircuits, the method comprising the following steps:
a) providing a sound responsive substrate, said substrate comprising a first laser-induced damage threshold, LIDT;
b) arranging an electrically conductive material on the substrate, wherein the electrically conductive material is also sound responsive and comprises a second LIDT, and wherein the second LIDT is comprised between 50% and 150% of the first LIDT;
c) patterning the electrically conductive material with one or more micromachining circuit patterns, by applying to the electrically conductive material, during one or more time intervals, a plurality of laser pulses comprising a delivered output power, using one or more femtosecond, fs, laser sources; wherein the delivered output power is equal or higher than the second LIDT, thereby ablating the electrically conductive material;
d) monitoring, during step c), a sound response of the electrically conductive material and of the substrate;
e) controlling, in response to the monitoring of step d), the delivery of output power of the laser pulses during one or more of the time intervals of step c), such that the delivered output power is adjusted to a value which is lower than the first LIDT, thereby avoiding ablating the substrate.

2. Method according to the preceding claim, wherein the micromachining circuit pattern comprises a transducer.

3. Method according to any of the preceding claims, wherein the substrate comprises a piezoelectric material, or a piezoelectric material comprising LiNbO₃, ZnO, AlN, BaTiO₃, quartz, PVDF or PVDF-TrFE.

4. Method according to any of the preceding claims, wherein the micromachining circuit pattern comprises one or several electrodes, IDTs, reflectors, antennas, micro electromechanical systems, microchannels or circuit probes.

5. Method according to the preceding claim, wherein the electrically conductive material comprises a conductive material, a conductive oxide material, a transparent conductive oxide, TCO, material, or a TCO material comprising ITO, AZO, GZO, or FTO, metal nanostructures, conducting polymers, or combinations of these materials forming composites or multilayers.

6. Method according to any of the preceding claims, wherein the electrically conductive material is arranged as a layer comprising a thickness of between 50 nm and 1000 nm.

7. Method according to any of the preceding claims, wherein the substrate comprises a supported layer, or is arranged on a support material comprising glass, ceramic, a metal or a polymer.

8. Method according to any of the preceding claims, wherein the application of laser pulses during step c) comprises one or more consecutive passes over a same region of the electrically conductive material, or a part thereof.

9. Method according to the preceding claim, wherein the one or more consecutive passes are applied at a same output power, or at a different output power.

10. Method according to any of claims 8-9, wherein the output power of one pass is less than the power of its consecutive pass.

11. Method according to any of claims 8-10, wherein the one or more consecutive passes are applied:
- parallel to each other over the region of the electrically conductive material; or
- with a different scanning angle over the region of the electrically conductive material.

12. Method according to any of the preceding claims, wherein:
- the laser pulses comprise a duration between 10 fs and 5000 fs, and/or a wavelength between 257 nm and 1030 nm;
- the one or more fs laser sources comprise a plurality of fs laser sources with different output powers, and step e) comprises selecting one of the plurality of fs laser sources; or
- the one or more fs laser sources comprise at least an infrared, IR, a green laser or an ultraviolet, UV, laser.

13. Method according to any of the preceding claims, further comprising an additional step of applying a pre- or post- treatment of thermal annealing, using a laser treatment or a normal furnace thermal treatment, to the arrangement of the electrically conductive material and the substrate.

14. System for manufacturing a microcircuit, said system comprising:
- one or more fs laser sources adapted for patterning an electrically conductive material arranged on a sound responsive substrate, by applying to the electrically conductive material, during one or more time intervals, a plurality of laser pulses comprising an output power;
- a sound monitoring system adapted to monitor a sound response of the substrate to the application of the laser pulses to the electrically conductive material;
- a controller communicatively connected to the one or more fs laser sources;
wherein the one or more fs laser sources, the sound sensor and the controller are adapted to perform the method according to any of the preceding claims.

15. Use of a system according to the preceding claim for manufacturing a transducer, an electrode, a reflector, an antenna, a microchannel, a micro electromechanical system, or a circuit probe.
